Europäisches Patentamt

European Patent Office

Office européen des brevets

(11) Veröffentlichungsnummer: **0 295 413 B1**

(12) **EUROPÄISCHE PATENTSCHRIFT**

(45) Veröffentlichungstag der Patentschrift: **07.10.92**

(51) Int. Cl.⁵: **G01R 1/067**, G01R 31/28, G02F 1/03

(21) Anmeldenummer: **88107233.4**

(22) Anmeldetag: **05.05.88**

(54) **Mechanische Sonde zur optischen Messung elektrischer Potentiale.**

(30) Priorität: **09.06.87 DE 3719204**

(43) Veröffentlichungstag der Anmeldung:
**21.12.88 Patentblatt 88/51**

(45) Bekanntmachung des Hinweises auf die
Patenterteilung:
**07.10.92 Patentblatt 92/41**

(84) Benannte Vertragsstaaten:
**DE FR GB NL**

(56) Entgegenhaltungen:
**US-A- 4 618 819**

**ELECTRONICS LETTERS, Band 22, Nr. 17, 14. August 1986, Seiten 918-919; J. NEES et al.: "Noncontact electro-optic sampling with a GaAs injection laser"**

**EXTENDED ABSTRACTS, Band 87-1, Nr. 1, Frühjahr 1987, Seiten 181-182, Philadelphia, PA, US; J.A. VALDMANIS et al.: "A non-contact electro-optic prober for high speed integrated circuits"**

**IEEE JOURNAL OF QUANTUM ELECTRONICS,**

**Band OE-22, Nr. 1, Januar 1986, Seiten 69-78, IEEE; J.A. VALDMANIS et al.: "Subpicosecond electrooptic sampling: principles and applications"**

(73) Patentinhaber: **SIEMENS AKTIENGESELL-SCHAFT**
**Wittelsbacherplatz 2**
**W-8000 München 2(DE)**

(72) Erfinder: **Sölkner, Gerald, Dipl.-Ing.**
**Naupliaallee 12**
**W-8012 Ottobrunn(DE)**

# Beschreibung

Die Erfindung betrifft eine mechanische Sonde zur optischen Messung elektrischer Potentiale nach dem Oberbegriff des Patentanspruchs 1.

Eine aus einem elektrooptischen Kristall bestehende Sonde ist aus der Veröffentlichung von J. A. Valdmanis "Subpicosecond electrical Sampling and applications" erschienen in Picosecond Optoelectronic Devices, Academic Press Inc. 1984, Seite 249 bis 270, insbesondere Seite 257 bis 258 und Figur 7, bekannt. Mit dieser Sonde können allerdings nur Messungen an speziellen Teststrukturen durchgeführt werden.

Eine für elektrooptische Sampling-Verfahren verwendbare Sonde ist aus den Electronics Letters, 14. Aug. 1986, Vol. 22 No. 17, S. 918-919 bekannt.

Der Erfindung liegt die Aufgabe zugrunde, eine mechanische Sonde der eingangs genannten Art anzugeben, mit der elektrische Potentiale bzw. Signale an beliebigen Punkten einer Probe, insbesondere einer mikroelektronischen Schaltung, optisch mit hoher Zeitauflösung gemessen werden können.

Diese Aufgabe wird erfindungsgemäß durch eine mechanische Sonde nach Patentanspruch 1 gelöst.

Der mit der Erfindung erzielbare Vorteil besteht insbesondere darin, daß Signale in integrierten Schaltungen berührungslos und mit hoher Zeitauflösung optisch gemessen werden können.

Die Ansprüche 2 bis 5 sind auf bevorzugte Ausgestaltungen und Weiterbildungen der Erfindung gerichtet.

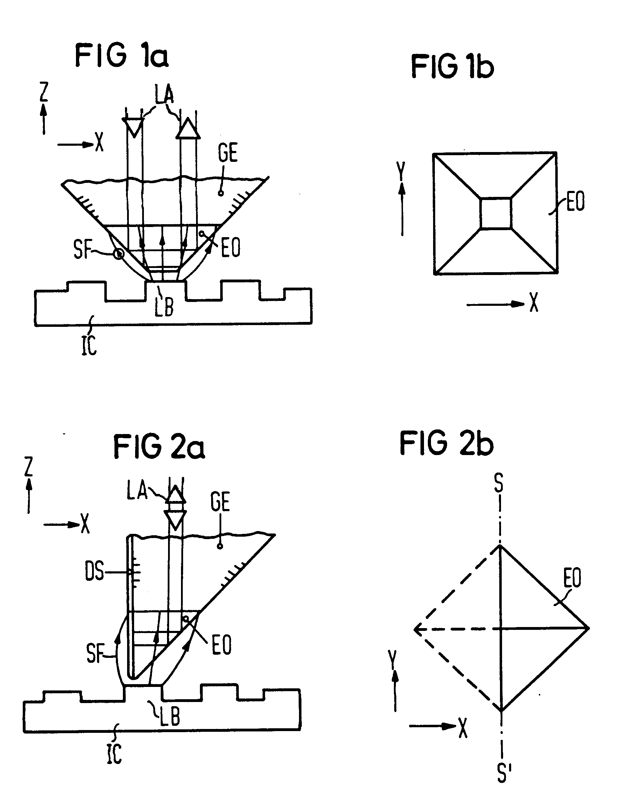

Die Erfindung wird nachfolgend anhand der Zeichnungen näher erläutert. Hierbei zeigen die FIG 1 und 2 Ausführungsbeispiele erfindungsgemäßer Sonden.

Die in FIG 1 schematisch dargestellte mechanische Sonde besteht im wesentlichen aus einem in Form einer Spitze ausgebildeten kubischen elektrooptischen Kristall EO, beispielsweise ZnTe, ZnSe oder GaAs, und einer auf Erdpotential liegenden Metallisierung GE, die den Kristall EO mit Ausnahme der der Meßstelle, beispielsweise der Leiterbahn LB eines Bauelementes der Mikroelektronik IC, unmittelbar gegenüberliegenden Oberflächenbereiche bedeckt. Da die als Gegenelektrode wirkende Metallisierung GE das Eindringen des elektrischen Streufeldes SF in den elektrooptischen Kristall EO wesentlich erleichtert, werden geometrieabhängige Effekte und Einflüsse elektrischer Mikrofelder nahezu vollständig unterdrückt. Mit der erfindungsgemäßen mechanischen Sonde ist es deshalb möglich, den Potentialkontrast anstelle des topographieabhängigen Feldkontrastes zur optischen Messung elektrischer Signale mit hoher Zeitauflösung auszunutzen. Aufgrund der guten Spaltbarkeit kubischer Kristalle, lassen sich sehr feine Spitzen (siehe FIG 1b) mit Durchmessern von wenigen Mikrometern erzeugen, so daß man auch moderne hochintegrierte Schaltungen mit einer solchen Sonde untersuchen und in ihrer Funktionsweise überprüfen kann. Die Zeitabhängigkeit des in die Leiterbahn LB eingespeisten Signals kann in bekannter Weise (siehe beispielsweise die eingangs zitierten Veröffentlichungen) unter Ausnutzung des elektrooptischen Effektes mit Hilfes eines das elektrische Streufeld SF in der Kristallspitze detektierenden Laserstrahls LA aufgezeichnet werden. Angewandt wird üblicherweise ein Sampling-Verfahren, bei dem man den in einem Raster-Lasermikroskop erzeugten polarisierten Laserstrahl LA synchron mit dem an der betreffenden Meßstelle anliegenden Signal eintastet und die Phasenlage der Laserpulse bezüglich dieses Signals, beispielsweise durch Verlängerung bzw. Verkürzung des Strahlengangs zwischen Laserquelle und Kristall, kontinuierlich verändert. Da die (1,1,1)-Richtung des kubischen Kristalls EO (Raumdiagonale des Würfels) senkrecht zur Bausteinoberfläche und damit parallel zur optischen Achse des Raster-Lasermikroskops orientiert ist, kann man den das elektrische Streufeld SF abtastenden Laserstrahl ohne aufwendige Spiegelsysteme durch Totalreflektion an den Kristallseitenflächen in Richtung des den Polarisationszustand detektierenden Meßsystems umlenken.

Zur Positionierung des etwa 0,5 bis 1 mm langen elektrooptischen Kristalls EO auf der Leiterbahn LB können konventionelle, aus der elektrischen Meßtechnik (Spitzenmeßplatz) bekannte Sondenhalter verwendet werden, die man mittels Magnet-oder Vakuumadaptern auf einer beispielsweise durch vier synchron laufende Leitspindeln exakt linear höhenverstellbaren Rahmen fixiert. Ein solcher Sondenhalter besteht üblicherweise aus einer Halterung zur Aufnahme der Sonde, einem Sondenarm und einer Feinmechanik, die eine lineare Verschiebung der Sonde in drei zueinander orthogonale Richtungen gestattet. Anstelle dieser Sondenhalter kann man auch elektrostriktive Manipulatoren mit einer für moderne hochintegrierte Schaltungen ausreichenden Positioniergenauigkeit von etwa 0,1 μm verwenden. Die Höhenpositionierung der Kristallspitze oberhalb der Leiterbahn LB gestaltet sich besonders einfach, wenn Interferenzeffekte mit der Bausteinoberfläche bzw. Änderungen der Totalreflektion bei der Entfernung der Kristallspitze von der Probenoberfläche ("Attenuated Total Reflection - ATR") ausgenutzt werden.

Wegen der Größe des elektrooptischen Kristalls EO (maximale Dicke im Bereich der Halterung etwa 0,5 mm) kann die Positionierung der Sonde auf der Bauelementoberfläche nur mit Hilfe eines zweiten optischen Systems kontrolliert werden. Eine Sonde die diesen Nachteil vermeidet, ist schematisch in FIG 2 dargestellt. Die Sonde besteht ebenfalls aus einem kubischen elektrooptischen Kristall EO und einer auf Erdpotential liegenden Metallisierung GE, die den Kristall EO mit Ausnahme der der Leiterbahn LB unmittelbar gegenüberliegenden Oberflächenbereiche bedeckt. Der Kristall EO ist hierbei durch Spaltung entlang der Linie S-S′ (siehe FIG 2b) so ausgebildet, daß er eine senkrecht zur Bausteinoberfläche orientierte Stirnfläche aufweist. Die der mit einer Reflexionsschicht DS (dielektrischer Spiegel) versehene Stirnfläche gegenüberliegende Seitenfläche schließt hierbei ein Winkel von 45° mit der Laserstrahlrichtung und damit mit der (1,1,1)-Richtung des kubischen Kristalls EO ein. Diese Ausführungsform bietet gegenüber der in FIG 1 dargestellten Sonde den Vorteil, daß die Potentialmessung und die Spitzenpositionierung mit demselben optischen System (Raster-Lasermikroskop) durchgeführt werden kann.

**Patentansprüche**

1. Mechanische Sonde zur optischen Messung elektrischer Potentiale mit einem von einem Lichtstrahl (LA) durchsetzten elektrooptischen Kristall (EO), der in unmittelbarer Nähe einer Probe (IC) angeordnet ist, dadurch **gekennzeichnet,** daß der eine kubische Struktur aufweisende Kristall (EO) in Form einer Spitze ausgebildet ist und daß eine Elektrode (GE) derart auf dem Kristall (EO) angeordnet ist, daß sie dessen probenseitige Oberflächenbereiche unbedeckt läßt.

2. Mechanische Sonde nach Anspruch 1, dadurch **gekennzeichnet,** daß die (1,1,1)-Richtung des Kristalls (EO) senkrecht zur kristallseitigen Oberfläche der Probe (IC) orientiert ist.

3. Mechanische Sonde nach Anspruch 1 oder 2, dadurch **gekennzeichnet,** daß der Kristall (EO) eine mit einer reflektierenden Schicht (DS) versehene erste Seitenfläche aufweist, wobei die erste Seitenfläche senkrecht zur kristallseitigen Oberfläche der Probe (IC) orientiert ist.

4. Mechanische Sonde nach Anspruch 3, dadurch **gekennzeichnet,** daß eine zweite Seitenfläche des Kristalls (EO) einen Winkel von 45° mit der ersten Seitenfläche einschließt.

5. Mechanische Sonde nach einem der Ansprüche 1 bis 4, dadurch **gekennzeichnet,** daß eine Metallisierung als Elektrode (GE) vorgesehen ist.

**Claims**

1. Mechanical probe for the optical measurement of electrical potentials, having an electro-optical crystal (EO), which is penetrated by a light beam (LA) and which is disposed in the immediate vicinity of a specimen (IC), characterised in that the crystal (EO), which exhibits a cubic structure, is designed in the form of a tip, and in that an electrode (GE) is disposed on the crystal (EO) in such a manner that the electrode leaves the specimen-side surface regions of the crystal uncovered.

2. Mechanical probe according to Claim 1, characterised in that the (1,1,1) direction of the crystal (EO) is oriented perpendicular to the crystal-side surface of the specimen (IC).

3. Mechanical probe according to Claim 1 or 2, characterised in that the crystal (EO) exhibits a first lateral face provided with a reflective layer (DS), the first lateral face being oriented perpendicular to the crystal-side surface of the specimen (IC).

4. Mechanical probe according to Claim 3, characterised in that a second lateral face of the crystal (EO) includes an angle of 45° with the first lateral face.

5. Mechanical probe according to one of Claims 1 to 4, characterised in that a metallisation is provided as electrode (GE).

**Revendications**

1. Sonde mécanique pour la mesure optique de potentiels électriques comportant un cristal électro-optique (EO) traversé par un faisceau de lumière (LA) et qui est disposé à proximité d'un échantillon (IC), caractérisée par le fait que le cristal (EO), qui possède une structure cubique, est agencé sous la forme d'une pointe et qu'une électrode (GE) est disposée sur le cristal (EO) de telle sorte qu'elle laisse à découvert les zones superficielles du cristal situées du côté de l'échantillon.

2. Sonde mécanique suivant la revendication 1, caractérisée par le fait que la direction (1,1,1) du cristal (EO) est perpendiculaire à la surface de l'échantillon (IC), tournée vers le cristal.

3. Sonde mécanique suivant la revendication 1 ou 2, caractérisée par le fait que le cristal (EO) possède une première surface latérale comportant une couche réfléchissante (DS), la première surface latérale étant perpendiculaire à la surface de l'échantillon (IC), tournée du côté du cristal.

4.  Sonde mécanique suivant la revendication 3, caractérisée par le fait qu'une seconde surface latérale du cristal (EO) fait un angle de 45° par rapport à la première surface latérale.

5.  Sonde mécanique suivant l'une des revendications 1 à 4, caractérisée par le fait qu'il est prévu une métallisation en tant qu'électrode (GE).

# FIG 1a

# FIG 1b

# FIG 2a

# FIG 2b